# EUROPÄISCHE PATENTSCHRIFT

(11) **EP 3 931 582 B1**
(45) Veröffentlichungstag und Bekanntmachung des Hinweises auf die Patenterteilung: **04.11.2026**
(21) Anmeldenummer: 20704413.2
(22) Anmeldetag: 27.01.2020
(51) Int. Cl.: G01R 31/00, B61L 7/06, B61L 27/53, B61L 5/06

(54) **VERFAHREN ZUM ÜBERWACHEN EINER WEICHE EINER EISENBAHNGLEISANLAGE**
METHOD FOR MONITORING POINTS OF A RAILWAY TRACK INSTALLATION
PROCÉDÉ DE SURVEILLANCE D'UN AIGUILLAGE D'UNE INSTALLATION FERROVIAIRE

(30) Priorität: 27.02.2019 DE 102019202631
(43) Veröffentlichungstag der Anmeldung: 05.01.2022
(73) Patentinhaber: Siemens Mobility GmbH, 80997 München (DE)
(72) Erfinder: WORM, Katja, 10439 Berlin (DE)
(74) Vertreter: Siemens Patent Attorneys
(86) Internationale Anmeldenummer: PCT/EP2020/051873
(87) Internationale Veröffentlichungsnummer: WO 2020/173636

(56) Entgegenhaltungen:
- EP-A1- 3 305 622
- WO-A1-2005/015326
- DE-A1- 10 023 093
- DE-A1- 102016 221 479

## Beschreibung

Die Erfindung bezieht sich auf Verfahren und Einrichtungen, die ein besonders zuverlässiges Überwachen von Weichen einer Eisenbahngleisanlage ermöglichen oder eine Basis dafür, insbesondere in Form eines Klassifikationsmodells, schaffen.

Aus der koreanischen Patentschrift KR 101823067 B1 ist ein Verfahren zum Überwachen einer Weiche einer Eisenbahngleisanlage bekannt. Bei dem vorbekannten Verfahren wird die Stromaufnahme eines Weichenantriebs der Weiche für eine als funktionsfähig angesehene bzw. als fehlerfrei angesehene Weiche erfasst und es werden entsprechende Referenzwerte abgespeichert. Wird im nachfolgenden Weichenbetrieb festgestellt, dass aktuelle Messwerte mit den Referenzmesswerten nicht korrelieren, so wird ein entsprechendes Fehlersignal erzeugt, das einen Fehler der Weiche anzeigt.

Das Dokument US 2018 0154 913 A1 beschreibt ein computerimplementiertes Verfahren zum Benachrichtigen eines Benutzers über das Vorhandensein eines Fehlers in einem elektromechanischen System in einer Eisenbahninfrastruktur. Das Verfahren umfasst das Empfangen von elektrischen Nutzungsdaten, die den Wert eines elektrischen Nutzungsparameters angeben, der dem elektromechanischen System zugeordnet ist sowie das Empfangen von Temperaturdaten, die die aktuelle Temperatur des elektromechanischen Systems anzeigen. Ferner wird ermittelt - basierend auf einer vorbestimmten Beziehung zwischen dem elektrischen Gebrauchsparameter und der Temperatur **-,** ob der Wert des elektrischen Gebrauchsparameters einen Fehler im elektromechanischen System anzeigt. Ist dies der Fall, erfolgt eine Warnung, um das Vorhandensein des Fehlers anzuzeigen.

Dokument WO 2005/015326 A1 beschreibt ein System zum Überwachen des Zustands von Installationen wie Eisenbahnen, Pipelines, Rolltreppen sowie Aufzügen und umfasst einen Datenprozessor, der mehrere separate Merkmalsdetektoren umfasst, von denen jeder einen spezifischen Aspekt der von der Installation erhaltenen Daten überwacht. Die Merkmalsdetektoren umfassen ein Normalitätsmodell, das aus Trainingsdatensätzen gelernt werden kann, und vergleichen dann die Eingangssignale mit dem Normalitätsmodell, um Abweichungen von der Normalität zu erkennen.

Dokument DE 10 2016 221479 A1 betrifft ein Verfahren zur Weichendiagnose. Für eine Gruppe von mehreren Weichenantrieben, die eine gemeinsame Stromversorgung aufweisen, werden Messwerte erfasst, die sich auf zumindest eine gemeinsame elektrische Messgröße beziehen, insbesondere in Form eines gemeinsamen Stellstroms der Weichenantriebe, einer gemeinsamen Stellspannung der Weichenantriebe und/oder einer von den Weichenantrieben aufgenommenen gemeinsamen Wirkleistung.

Der Erfindung liegt u. a. die Aufgabe zugrunde, ein Verfahren zum Ermitteln eines Klassifikationsmodells anzugeben, das die Überwachung einer Weiche einer Eisenbahngleisanlage besonders zuverlässig ermöglicht.

Zur Lösung dieser Aufgabe ist erfindungsgemäß ein Verfahren mit den Merkmalen gemäß Patentanspruch 1 vorgesehen. Vorteilhafte Ausgestaltungen dieses Verfahrens sind in Unteransprüchen angegeben.

Danach ist erfindungsgemäß vorgesehen, dass für eine Mehrzahl an Weichenumläufen jeweils ein Referenzumlaufdatensatz ermittelt wird, der sich jeweils auf zumindest zwei während des jeweiligen Weichenumlaufs gemessene physikalische Messgrößen bezieht, und ein Klassifikationsmodell auf der Basis dieser Mehrzahl an Referenzumlaufdatensätzen ermittelt wird.

Außerdem ist vorgesehen, dass eine Weichenüberwachung nicht anhand einer einzelnen physikalischen Messgröße (dort ist es der Strom) erfolgt, sondern auf der Basis zumindest zweier bzw. mehrerer Messgrößen, wodurch ein erweitertes Klassifikationsmodell gebildet und eine besonders zuverlässige Fehlererkennung ermöglicht wird.

Als vorteilhaft wird es angesehen, wenn das Klassifikationsmodell unter Heranziehung oder auf der Basis ausschließlich solcher Referenzumlaufdatensätze ermittelt wird, deren zugehörige Weichenumläufe als fehlerfrei angesehen werden.

Für jeden Weichenumlauf der Weiche wird als Referenzumlaufdatensatz ein zumindest zweidimensionaler, einem vorgegebenen Vektorraum zugeordneter Merkmalsvektor erstellt, dessen zumindest zwei Vektorkomponenten sich auf die zumindest zwei während des Weichenumlaufs gemessenen physikalischen Messgrößen beziehen.

Mit den Merkmalsvektoren wird ein Raumabschnitt innerhalb des Vektorraumes definiert, der das Klassifikationsmodell bildet und zur Bildung des Fehlersignals eine Prüfung ermöglicht, ob nach Fertigstellung des Klassifikationsmodells für nachfolgende Weichenumläufe erzeugte Merkmalsvektoren über ein vorgegebenes Maß hinaus außerhalb dieses Raumabschnitts liegen oder nicht.

Erfindungsgemäß ist vorgesehen, dass das Klassifikationsmodell zunächst auf der Basis von Referenzumlaufdatensätzen ermittelt wird, die sich auf eine vorgegebene Anzahl an Weichenumläufen nach einer Erstinstallation der Weiche oder auf eine vorgegebene Zeitspanne nach der Erstinstallation der Weiche beziehen. Solche nach der Erstinstallation erstellten Referenzumlaufdatensätze definieren nämlich mit überwiegender Wahrscheinlichkeit eine funktionsfähige Weiche und bilden Positivbeispiele für eine funktionsfähige Weiche.

Außerdem ist erfindungsgemäß vorgesehen, dass nach einer jeden Reparatur oder Wartung ein bestehendes Klassifikationsmodell unter Bildung eines aktualisierten Klassifikationsmodells auf der Basis von Referenzumlaufdatensätzen modifiziert wird, die sich auf eine vorgegebene Anzahl an Weichenumläufen nach der jeweiligen Wartung oder Reparatur der Weiche oder auf eine vorgegebene Zeitspanne nach der jeweiligen Wartung oder Reparatur der Weiche beziehen.

Zusätzlich ist also vorgesehen, dass das Klassifikationsmodell zumindest auch auf der Basis von Referenzumlaufdatensätzen ermittelt wird, die sich auf eine vorgegebene Anzahl an Weichenumläufen nach einer Wartung der Weiche oder auf eine vorgegebene Zeitspanne nach der Wartung der Weiche beziehen. Solche nach einer Wartung erstellten Referenzumlaufdatensätze definieren nämlich mit überwiegender Wahrscheinlichkeit eine funktionsfähige Weiche und bilden Positivbeispiele für eine funktionsfähige Weiche.

Zusätzlich ist vorgesehen, dass das Klassifikationsmodell zumindest auch auf der Basis von Referenzumlaufdatensätzen ermittelt wird, die sich auf eine vorgegebene Anzahl an Weichenumläufen nach einer Reparatur der Weiche oder auf eine vorgegebene Zeitspanne nach der Reparatur der Weiche beziehen. Solche nach einer Reparatur erstellten Referenzumlaufdatensätze definieren nämlich mit überwiegender Wahrscheinlichkeit eine funktionsfähige Weiche und bilden Positivbeispiele für eine funktionsfähige Weiche.

Damit wird das erfindungsgemäße Verfahren durchgeführt, indem ein erstes Klassifikationsmodell auf der Basis von Referenzumlaufdatensätzen ermittelt wird, die sich auf eine vorgegebene Anzahl an Weichenumläufen nach der Erstinstallation der Weiche oder auf eine vorgegebene Zeitspanne nach der Erstinstallation der Weiche beziehen. Nachfolgend kann das erste Klassifikationsmodell in vorteilhafter Weise unter Bildung eines zweiten Klassifikationsmodells auf der Basis von Referenzumlaufdatensätzen modifiziert werden, die sich auf eine vorgegebene Anzahl an Weichenumläufen nach einer erstmaligen Wartung oder erstmaligen Reparatur der Weiche oder auf eine vorgegebene Zeitspanne nach einer erstmaligen Wartung oder erstmaligen Reparatur der Weiche beziehen.

Die Referenzumlaufdatensätze geben vorzugsweise jeweils zumindest auch als eine der gemessenen physikalischen Messgrößen die Umlaufdauer der Weiche an. Die Umlaufdauer der Weiche ist eine besonders geeignete Messgröße zur Erkennung von Fehlern.

Das Klassifikationsmodell wird besonders bevorzugt unter Heranziehung oder auf der Basis eines One-Class-Support-Vector-Machine-Verfahrens ermittelt.

Bei der Bildung des zweiten und/oder aktualisierten Klassifikationsmodells kann in vorteilhafter Weise für Referenzumlaufdatensätze, die außerhalb eines von dem jeweils vorherigen Klassifikationsmodell als zulässiger Weichenzustand definierten Weichenzustandsbereichs liegen, ein Warnsignal erzeugt werden. Bei Vorliegen von Warnsignalen kann eine Überprüfung der Messung und/oder der Weichenfunktion erfolgen.

Die Erfindung kann wie folgt bei einem Verfahren zum Feststellen eines Fehlers in einer Weiche innerhalb einer Eisenbahngleisanlage zum Einsatz kommen. Bezüglich eines solchen Verfahrens ist vorgesehen, dass während oder nach Abschluss eines Weichenumlaufs der Weiche ein Umlaufdatensatz erstellt wird, der sich auf zumindest zwei während des Weichenumlaufs gemessene physikalische Messgrößen bezieht, der Umlaufdatensatz mit einem Klassifikationsmodell, das gemäß einem Verfahren - wie oben beschrieben - für dieselben zumindest zwei Messgrößen ermittelt worden ist, abgeglichen wird und im Falle, dass der Umlaufdatensatz außerhalb eines von dem Klassifikationsmodell als zulässiger Weichenzustand definierten Weichenzustandsbereichs liegt, ein ein Fehlverhalten der Weiche anzeigendes Fehlersignal erzeugt wird. Dieses letztgenannte Verfahren beruht somit auf einer Verwendung des erfindungsgemäßen Klassifikationsmodells, das auf zumindest zwei physikalischen Messgrößen basiert und somit besonders zuverlässig durchführbar ist; diesbezüglich sei auf die obigen Ausführungen im Zusammenhang mit dem Verfahren zum Ermitteln eines Klassifikationsmodells verwiesen, die hier entsprechend gelten.

Die Erfindung bezieht sich darüber hinaus auf eine Einrichtung zum Ermitteln eines Klassifikationsmodells für eine Weiche einer Eisenbahngleisanlage, das ein Feststellen des Fehlers der Weiche ermöglicht. Bezüglich einer solchen Einrichtung ist erfindungsgemäß vorgesehen, dass die Einrichtung dazu ausgebildet ist, das Klassifikationsmodell auf der Basis einer Mehrzahl an Referenzumlaufdatensätzen zu ermitteln, die sich jeweils auf zumindest zwei während des jeweiligen Weichenumlaufs gemessene physikalische Messgrößen beziehen. Bezüglich der Vorteile der erfindungsgemäßen Einrichtung sei auf die obigen Ausführungen im Zusammenhang mit dem erfindungsgemäßen Verfahren zum Ermitteln eines Klassifikationsmodells verwiesen, da diese Ausführungen hier entsprechend gelten.

Die Erfindung kann wie folgt in einer Einrichtung zum Feststellen eines Fehlers einer Weiche einer Eisenbahngleisanlage zum Einsatz kommen. Dabei ist vorgesehen, dass die Einrichtung dazu ausgebildet ist, während oder nach Abschluss eines Weichenumlaufs der Weiche einen Umlaufdatensatz zu erstellen, der sich auf zumindest zwei während des Weichenumlaufs gemessene physikalische Messgrößen bezieht, den Umlaufdatensatz mit dem erfindungsgemäßen Klassifikationsmodell, das auf der Basis einer Mehrzahl an Referenzumlaufdatensätzen ermittelt worden ist, abzugleichen und im Falle, dass der Umlaufdatensatz außerhalb eines von dem Klassifikationsmodell als zulässiger Weichenzustand definierten Weichenzustandsbereichs liegt, ein ein Fehlverhalten der Weiche anzeigendes Fehlersignal zu erzeugen.

Vorteilhaft ist es, wenn die genannten Einrichtungen eine Recheneinrichtung und einen Speicher aufweisen, in dem ein Computerprogrammprodukt abgespeichert ist, das bei Ausführung durch die Recheneinrichtung diese veranlasst, eines oder alle der oben beschriebenen Verfahren durchzuführen.

Die Erfindung bezieht sich darüber hinaus auf ein Computerprogrammprodukt, das geeignet ist, bei Ausführung durch eine Recheneinrichtung diese zu veranlassen, eines oder alle der oben beschriebenen Verfahren durchzuführen.

Die Erfindung wird nachfolgend anhand von Ausführungsbeispielen näher erläutert; dabei zeigen beispielhaft
- Figur 1: anhand eines Flussdiagramms ein erstes Ausführungsbeispiel für ein erfindungsgemäßes Verfahren,
- Figur 2: anhand eines Flussdiagramms ein zweites Ausführungsbeispiel für ein erfindungsgemäßes Verfahren,
- Figur 3: anhand eines Blockschaltbilds ein Ausführungsbeispiel für eine erfindungsgemäße Einrichtung zum Ermitteln eines Klassifikationsmodells,
- Figur 4: anhand eines Blockschaltbilds ein zweites Ausführungsbeispiel für eine Einrichtung zum Ermitteln eines Klassifikationsmodells,
- Figur 5: anhand eines Flussdiagramms ein Ausführungsbeispiel für ein erfindungsgemäßes Verfahren zum Überwachen einer Weiche einer Eisenbahngleisanlage,
- Figur 6: anhand eines Blockschaltbilds ein erstes Ausführungsbeispiel für eine Einrichtung zum Feststellen eines Fehlers einer Weiche einer Eisenbahngleisanlage und
- Figur 7: anhand eines Blockschaltbilds ein zweites Ausführungsbeispiel für eine Einrichtung zum Feststellen eines Fehlers einer Weiche einer Eisenbahngleisanlage.

In den Figuren werden der Übersicht halber für identische oder vergleichbare Komponenten stets dieselben Bezugszeichen verwendet.

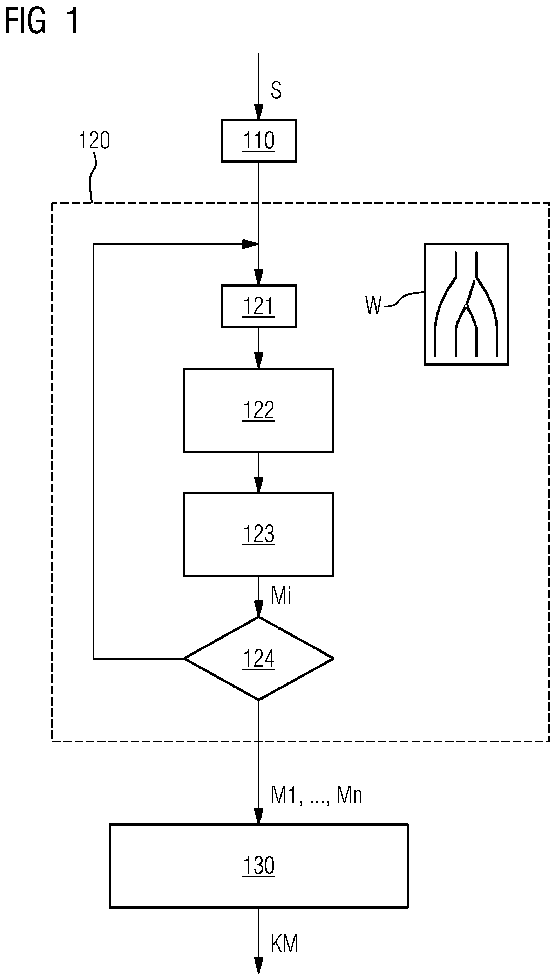

Die Figur 1 zeigt anhand eines Flussdiagramms ein Ausführungsbeispiel für ein Verfahren zum Ermitteln eines Klassifikationsmodells **KM,** das ein Feststellen eines Fehlers einer Weiche W einer Eisenbahngleisanlage anhand von während eines Weichenumlaufs gemessenen Messwerten ermöglicht.

Im Rahmen eines Verfahrensschritts 110 wird überwacht, ob ein Startsignal S zum Starten des Verfahrens bzw. zum Starten der Ermittlung des Klassifikationsmodells KM vorliegt. Ist dies der Fall, so wird mit einer nachfolgenden Erfassungsprozedur 120 zum Erfassen von Referenzumlaufdatensätzen begonnen.

Im Rahmen der Erfassungsprozedur 120 wird zunächst ein Überwachungsschritt 121 zum Erkennen und Überwachen des jeweils nächsten Weichenumlaufs gestartet. Wird der Beginn eines neuen Weichenumlaufs im Verfahrensschritt 121 erkannt, so werden in einem nachfolgenden Verfahrensschritt 122 für den jeweiligen Weichenumlauf jeweils zumindest zwei physikalische Messgrößen messtechnisch erfasst. Bei den physikalischen Messgrößen kann es sich beispielsweise um die Stromaufnahme bzw. den maximalen Strom eines elektrischen Antriebsmotors der jeweiligen Weiche W oder die Weichenumlaufzeit der Weiche W handeln. Alternativ oder zusätzlich können auch weitere physikalische Messgrößen berücksichtigt werden, wie beispielsweise die maximale elektrische Leistungsaufnahme und/oder ein etwaiger Phasenversatz zwischen Strom und Spannung am Antriebsmotor der Weiche **W.**

In einem nachfolgenden Verfahrensschritt 123 wird für den jeweiligen Weichenumlauf jeweils ein Referenzumlaufdatensatz ermittelt, der sich auf die zumindest zwei physikalischen Messgrößen bezieht. Nachfolgend wird beispielhaft davon ausgegangen, dass als Referenzumlaufdatensatz ein zwei- oder mehrdimensionaler Merkmalsvektor erstellt wird, dessen Vektorkomponenten sich auf die während des jeweiligen Weichenumlaufs gemessenen physikalischen Messgrößen beziehen.

In der Figur 1 ist der im Verfahrensschritt 123 gebildete Merkmalsvektor mit dem Bezugszeichen Mi bezeichnet, wobei der Index i den i-ten Weichenumlauf nach Vorliegen des Startsignals S bezeichnet. Der Merkmalsvektor M1 würde somit den ersten Merkmalsvektor nach Vorliegen des Startsignals S bezeichnen, der Merkmalsvektor Mn den n-ten Merkmalsvektor nach Vorliegen des Startsignals S.

Werden beispielsweise zwei physikalische Messgrößen wie Stromaufnahme und Weichenumlaufzeit gemessen, so würde der Merkmalsvektor beim i-ten Weichenumlauf nach Eingang des Startsignals S ein zweidimensionaler Vektor sein, der beispielsweise wie folgt lautet: $Mi = \left(I, T\right)$ wobei I den Strom während des i-ten Weichenumlaufs und T die Umlaufdauer während des i-ten Weichenumlaufs bezeichnet.

In einem nachfolgenden Verfahrensschritt 124 wird geprüft, ob nach Eingabe des Startsignals S bereits ausreichend viele Weichenumläufe erfasst worden sind bzw. eine vorgegebene Mindestanzahl an Umläufen erreicht worden ist. Beispielsweise kann im Verfahrensschritt 124 geprüft werden, ob eine Anzahl n = 10 an Weichenumläufen erfasst worden ist. Ist dies der Fall, so werden im Verfahrensschritt 124 die gemessenen Merkmalsvektoren M1,...,M10 ausgegeben. Falls die Anzahl n = 10 an Weichenumläufen noch nicht erreicht worden ist, wird mit dem Verfahrensschritt 121 die weitere Überwachung von Weichenumläufen fortgesetzt, bis die vorgegebene Anzahl an Weichenumläufen erreicht worden ist.

Anstelle einer vorgegebenen Anzahl an Weichenumläufen kann im Verfahrensschritt 124 auch geprüft werden, ob eine vorgegebene Zeitspanne T nach Eingabe des Startsignals S verstrichen ist. Ist dies der Fall, wird mit dem Verfahrensschritt 130 fortgefahren, andernfalls wird die Aufnahme des jeweils nächsten Merkmalsvektors mit dem Verfahrensschritt 121 fortgesetzt.

Nach Abschluss der Erfassungsprozedur 120 wird in dem nachfolgenden Verfahrensschritt 130 auf der Basis der erzeugten Merkmalsvektoren M1,...,Mn das Klassifikationsmodell KM erzeugt. Als besonders vorteilhaft wird es angesehen, wenn das Klassifikationsmodell KM unter Heranziehung oder auf der Basis eines One-Class-Support-Vektor-Machine-Verfahrens ermittelt wird. Diesbezüglich wird hier auf die bekannte Literatur verwiesen, in der die Erzeugung von Klassifikationsmodellen auf der Basis von One-Class-Support-Vektor-Machine-Verfahren im Detail beschrieben ist, zum Beispiel:
- "Support Vector Method for Novelty Detection", Bernhard Schölkopf, Robert Williamson, Alex Smola, John Shawe-Taylor, John Platt, Advances in Neural Information Processing Systems 12, June 2000, Pages 582-588, MIT Press,
   und
- "Estimating the Support of a High-Dimensional Distribution", Bernhard Schölkopf, John C. Platt, John C. Shawe-Taylor,Alex J. Smola, Robert C. Williamson, Neural Computation archive, Volume 13 Issue 7, July 2001, Pages 1443 - 1471, MIT Press Cambridge, MA, USA

Zusammengefasst wird das Klassifikationsmodell KM bei dem Verfahren gemäß Figur 1 auf der Basis von Merkmalsvektoren bzw. Referenzumlaufdatensätzen erstellt, die sich auf eine vorgegebene Anzahl an Weichenumläufen nach Vorliegen des Startsignals S oder auf innerhalb einer vorgegebenen Zeitspanne nach Vorliegen des Startsignals S erfolgte Weichenumläufe beziehen.

Wird das Startsignal S nach einer Neuinstallation der Weiche W oder nach einer Wartung bzw. Reparatur der Weiche W erzeugt, so kann mit überwiegender Wahrscheinlichkeit davon ausgegangen werden, dass die Merkmalsvektoren M bzw. die entsprechenden Referenzumlaufdatensätze eine funktionsfähige bzw. fehlerfreie Weiche W charakterisieren und somit die Bildung eines Klassifikationsmodells ermöglichen, das auf das Erkennen fehlerfreier Weichenumläufe "trainiert" ist. Das Training erfolgt bei dem Verfahren gemäß Figur 1 also ausschließlich auf der Basis von Positivbeispielen, die sich auf fehlerfreie Weichenumläufe beziehen; Negativbeispiele für fehlerhafte Weichen sind für das Anlernen bzw. Trainieren des Klassifikationsmodells KM nicht erforderlich.

Bei dem Ausführungsbeispiel gemäß Figur 1 wird das Klassifikationsmodell KM auf der Basis eines One-Class-Support-Vektor-Machine-Verfahrens erzeugt; selbstverständlich können alternativ andere Verfahren eingesetzt werden, mit denen sich ein Klassifikationsmodell KM allein anhand von Positivbeispielen, also allein anhand von "als fehlerfrei" angesehenen Referenzumlaufdatensätzen, erstellen lässt. In diesem Zusammenhang können beispielsweise Verfahren genannt werden, die in den folgenden Literaturstellen beschrieben sind:
- "A Review of Novelty Detection", Marco A.F. Pimentel, David A. Clifton, Lei Clifton, Lionel Tarassenko, Signal Processing, Volume 99, June 2014, Pages 215-249, Elsevier,
- "A Survey of Recent Trends in One Class Classification", Shehroz S. Khan, Michael G. Madden, Artificial Intelligence and Cognitive Science, pages 188-197, 2009, Springer, und
- "Review of Novelty Detection Methods", Dubravko Miljkovic, The 33rd International Convention MIPRO, May 2010, IEEE

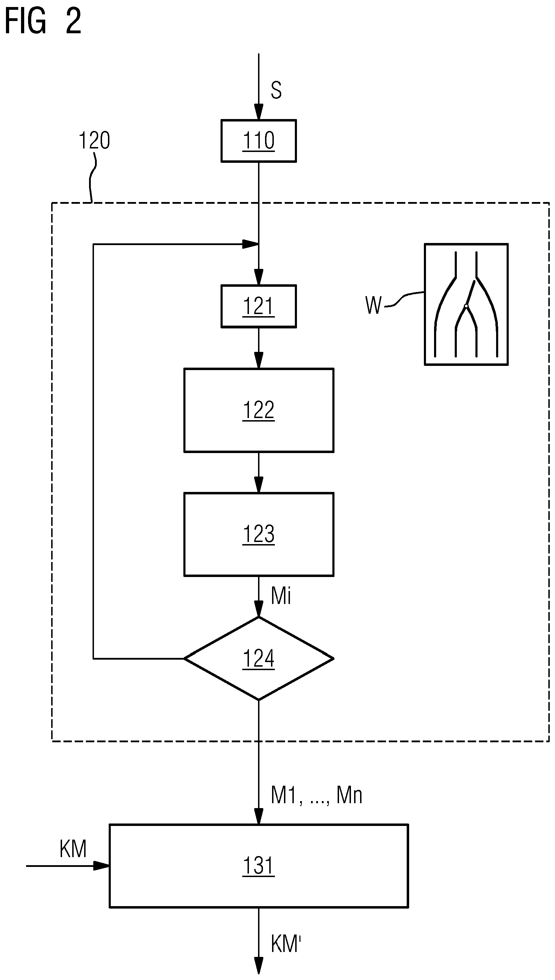

Die Figur 2 zeigt ein Verfahren zum Ermitteln eines Klassifikationsmodells KM', das auf der Basis eines bereits bestehenden Klassifikationsmodells KM durch Aktualisierung bzw. Modifikation dieses vorhandenen Klassifikationsmodells KM erstellt wird:
Nach Vorliegen eines Startsignals S und dem darauffolgenden Erfassen von Referenzumlaufdatensätzen in der Erfassungsprozedur 120 (siehe hierzu Ausführungen im Zusammenhang mit der Figur 1) wird in einem Modifikationsverfahren 131 das bereits bestehende Klassifikationsmodell KM auf der Basis der neu erzeugten Merkmalsvektoren M1,...,Mn modifiziert. Besonders einfach ist eine solche Modifikation möglich, indem die neu erzeugten Merkmalsvektoren M1,...,Mn in das bestehende Klassifikationsmodell KM integriert werden, wodurch das modifizierte bzw. neue Klassifikationsmodell KM' erzeugt wird.

Auch ist es möglich, die Merkmalsvektoren, die zur Bildung des vorhandenen Klassifikationsmodells KM herangezogen worden sind, gemeinsam mit den neu erzeugten Merkmalsvektoren M1,...,Mn zur Bildung des modifizierten bzw. neuen Klassifikationsmodells KM' heranzuziehen.

Im Übrigen gelten die obigen Ausführungen im Zusammenhang mit der Figur 1 bei dem Verfahren gemäß Figur 2 entsprechend.

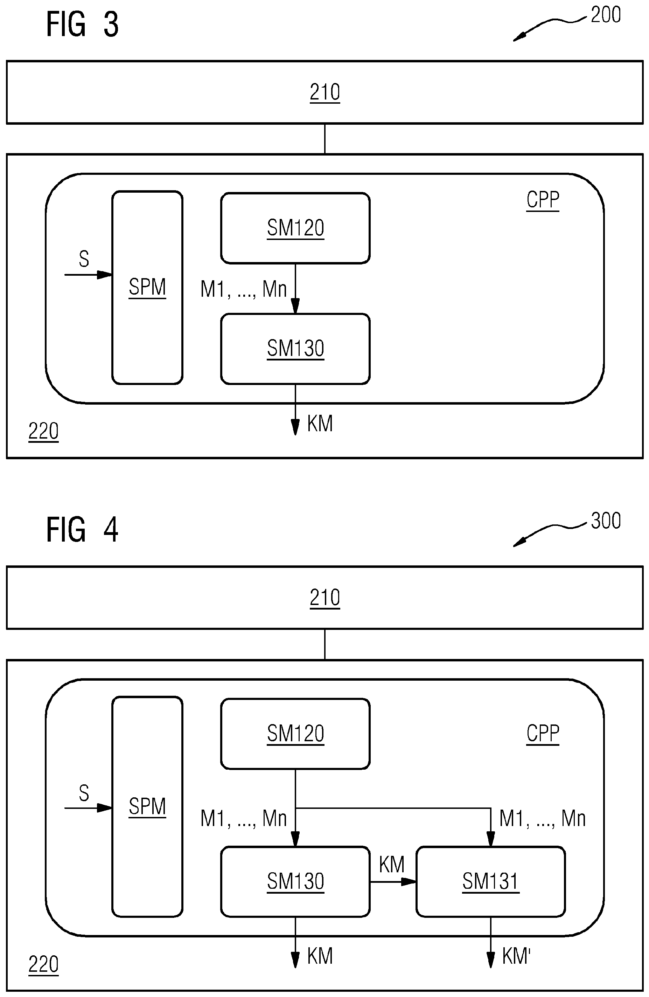

Die Figur 3 zeigt ein Ausführungsbeispiel für eine Einrichtung 200 zum Ermitteln eines Klassifikationsmodells KM. Die Einrichtung 200 umfasst eine Recheneinrichtung 210 und einen Speicher 220.

In dem Speicher 220 ist ein Computerprogrammprodukt CPP gespeichert, das ein Steuerprogrammmodul SPM, ein Softwaremodul SM120 und ein Softwaremodul SM130 zum Erzeugen eines Klassifikationsmoduls KM enthält. Die Softwaremodule SM120 und SM130 werden von dem Steuerprogrammmodul SPM gesteuert.

Das Softwaremodul SM120 führt die im Zusammenhang mit den Figuren 1 und 2 oben erläuterte Erfassungsprozedur 120, also die Verfahrensschritte 121 bis 124 zum Erzeugen von Referenzumlaufdatensätzen bzw. Merkmalsvektoren M aus, sobald das Steuerprogrammmodul SPM ein entsprechendes Startsignal S erhält.

Das Softwaremodul SM130 bildet - gesteuert durch das Steuerprogrammmodul SPM - mit den Referenzumlaufdatensätzen des Softwaremoduls SM120 bzw. den entsprechenden Merkmalsvektoren M das Klassifikationsmodell KM gemäß dem Verfahrensschritt 130, wie er im Zusammenhang mit den Figuren 1 und 2 oben erläutert worden ist.

Die Figur 4 zeigt ein Ausführungsbeispiel für eine Einrichtung 300, die nicht nur zum Erzeugen eines Klassifikationsmodells KM, sondern auch zur Modifikation eines bereits bestehenden Klassifikationsmodells KM und Erzeugen eines modifizierten Klassifikationsmodells KM' geeignet ist. Zu diesem Zweck weist die Einrichtung 300 ein zusätzliches Softwaremodul SM131 auf, das auf der Basis eines bereits zuvor erzeugten Klassifikationsmodells KM sowie auf der Basis neu erstellter Merkmalsvektoren M die Bildung eines aktualisierten bzw. modifizierten Klassifikationsmodells KM' durchführen kann, wie dies oben im Zusammenhang mit dem Ausführungsbeispiel gemäß Figur 2 bzw. dem entsprechenden Modifikationsverfahren 131 erläutert worden ist.

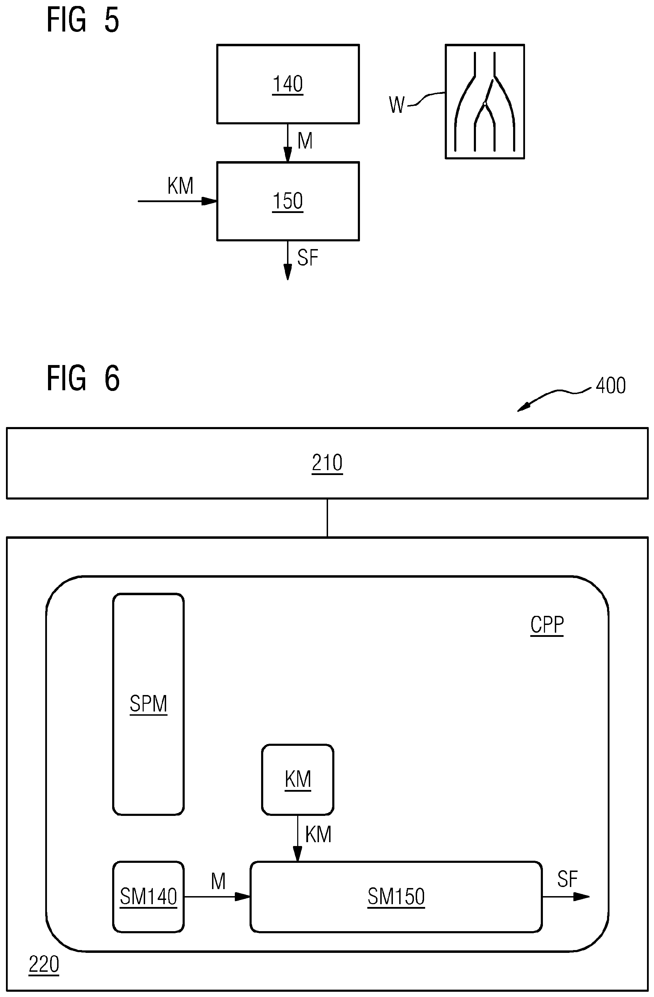

Die Figur 5 zeigt anhand eines Flussdiagramms ein Verfahren zum Feststellen eines Fehlers einer Weiche W einer Eisenbahngleisanlage. Im Rahmen eines Verfahrensschritts 140 wird ein jeder Weichenumlauf der Weiche W überwacht und es wird ein entsprechender Umlaufdatensatz, vorzugsweise in Form eines Merkmalsvektors M, erzeugt. In einem Auswertschritt 150 wird geprüft, ob der jeweilige Umlaufdatensatz gemäß einem vorgegebenen Klassifikationsmodell KM einen fehlerfreien Weichenumlauf charakterisiert. Wird festgestellt, dass der Umlaufdatensatz außerhalb eines von dem Klassifikationsmodell KM als zulässiger Weichenzustand definierten Weichenzustandsbereichs liegt, so wird ein Fehlersignal SF erzeugt.

Das Klassifikationsmodell KM ist im Rahmen des Verfahrens gemäß Figur 1 oder im Rahmen des Verfahrens gemäß Figur 2 erzeugt worden.

Die Figur 6 zeigt eine Einrichtung 400 zum Feststellen eines Fehlers einer Weiche W einer Eisenbahngleisanlage. Die Einrichtung 400 umfasst eine Recheneinrichtung 210 und einen Speicher 220. In dem Speicher 220 ist ein Computerprogrammprodukt CPP abgespeichert, das ein Steuerprogrammmodul SPM, ein Softwaremodul SM140, ein Softwaremodul SM150 und ein Klassifikationsmodell KM aufweist.

Stellt das Steuerprogrammmodul SPM fest, dass ein neuer Weichenumlauf stattfindet, so wird von dem Softwaremodul SM140 ein Umlaufdatensatz bzw. Merkmalsvektor M erzeugt, der den jeweiligen Weichenumlauf anhand zumindest zweier physikalischer Messgrößen charakterisiert.

Nachfolgend wird von dem Softwaremodul SM150 geprüft, ob der erfasste Umlaufdatensatz bzw. der Merkmalsvektor M außerhalb eines von dem Klassifikationsmodell KM als zusätzlicher Weichenzustand definierten Weichenzustandsbereichs liegt. Ist dies der Fall, so wird das Fehlersignal SF erzeugt.

Das Softwaremodul SM140 führt den Verfahrensschritt 140 aus, wie er im Zusammenhang mit der Figur 5 erläutert worden ist. Das Softwaremodul SM150 führt den Auswertschritt 150 aus, wie er im Zusammenhang mit der Figur 5 erläutert worden ist.

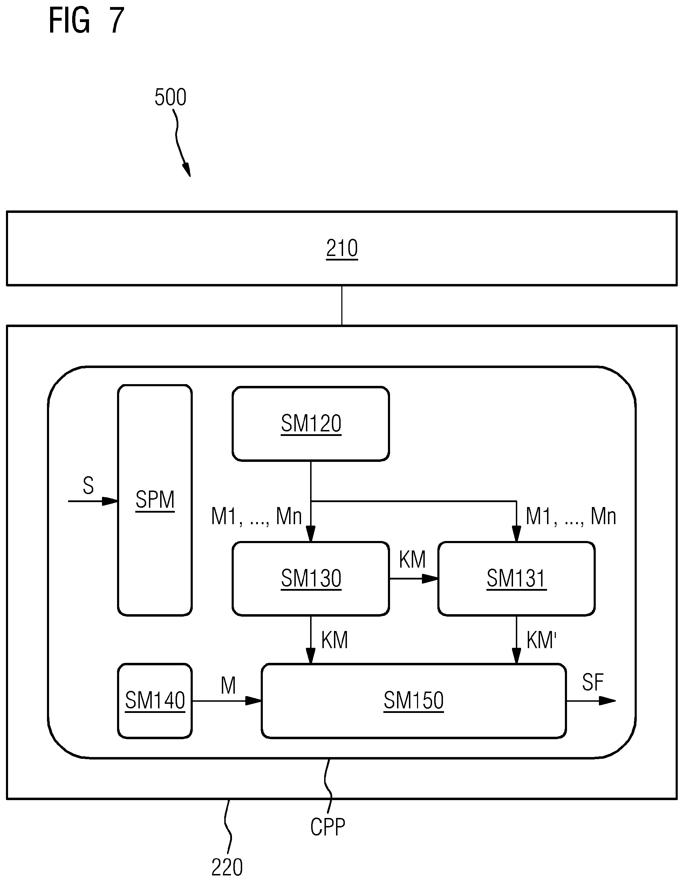

Die Figur 7 zeigt eine Einrichtung 500 zum Feststellen eines Fehlers einer Weiche W einer Eisenbahngleisanlage. Bei der Einrichtung gemäß Figur 7 sind zusätzlich zu den Softwaremodulen SM140 und SM150 die Softwaremodule SM120, SM130 und SM131 vorhanden, die zum Erzeugen eines Klassifikationsmodells KM sowie zum Modifizieren bzw. Aktualisieren eines bestehenden Klassifikationsmodells KM zur Bildung eines aktualisierten Klassifikationsmodells KM' geeignet sind. Bezüglich der Softwaremodule SM120, SM130 und SM131 sei auf die obigen Ausführungen im Zusammenhang mit den Figuren 3 und 4 verwiesen, die hier entsprechend gelten.

Bei dem Ausführungsbeispiel gemäß Figur 7 kann die Einrichtung 500 also nicht nur anhand von Umlaufdatensätzen bzw. neu gemessenen Merkmalsvektoren einen Fehler erkennen und ggf. ein Fehlersignal SF erzeugen, sondern darüber hinaus auch Klassifikationsmodelle KM erzeugen bzw. modifizierte Klassifikationsmodelle KM' bilden.

Das Steuerprogrammmodul SPM ist vorzugsweise derart ausgestaltet, dass es bei Vorliegen eines Startsignals S jeweils die Bildung eines Klassifikationsmodells KM mit Hilfe der Softwaremodule SM120 bzw. SM130 auslöst, sofern zuvor noch kein Klassifikationsmodell KM gebildet worden ist. Eine Neuerzeugung eines Klassifikationsmodells ist vorzugsweise nach der ersten Inbetriebnahme der Weiche W notwendig.

Liegt bereits ein zuvor erzeugtes Klassifikationsmodell KM vor, so wird bei Anliegen eines Startsignals S das Steuerprogrammmodul SPM vorzugsweise das Softwaremodul SM131 aktiviert, um das bestehende Klassifikationsmodell KM unter Bildung eines aktualisierten Klassifikationsmodells KM' zu aktualisieren. Eine Aktualisierung des jeweils vorhandenen Klassifikationsmodells erfolgt vorzugsweise jeweils nach jeder Wartung oder Reparatur.

Die Bildung eines ersten Klassifikationsmodells sowie die Bildung von aktualisierten Klassifikationsmodellen erfolgt vorzugsweise jeweils auf der Basis einer vorgegebenen Anzahl an Weichenumläufen nach Eingabe des Startsignals S bzw. innerhalb einer vorgegebenen Zeitspanne nach Eingabe eines Startsignals S. Ein Startsignal S wird vorzugsweise nach einer Neuinstallation der Weiche W sowie nach einer Wartung und/oder Reparatur der Weiche W erzeugt und in das Steuerprogrammmodul SPM eingegeben.

### Bezugszeichenliste

- 110: Verfahrensschritt
- 120: Erfassungsprozedur
- 121: Überwachungsschritt
- 122: Verfahrensschritt
- 123: Verfahrensschritt
- 124: Verfahrensschritt
- 130: Verfahrensschritt
- 131: Modifikationsverfahren
- 140: Verfahrensschritt
- 150: Auswertschritt
- 200: Einrichtung
- 210: Recheneinrichtung
- 220: Speicher
- 300: Einrichtung
- 400: Einrichtung
- 500: Einrichtung

- CPP: Computerprogrammprodukt
- KM: Klassifikationsmodell
- KM': Klassifikationsmodell
- M1: Merkmalsvektor
- M: Merkmalsvektor
- Mi: Merkmalsvektor
- Mn: Merkmalsvektor
- S: Startsignal
- SF: Fehlersignal
- SM120: Softwaremodul
- SM130: Softwaremodul
- SM131: Softwaremodul
- SM140: Softwaremodul
- SM150: Softwaremodul
- SPM: Steuerprogrammmodul
- W: Weiche

## Patentansprüche

1. Verfahren zum Ermitteln eines Klassifikationsmodells (KM, KM') für eine Weiche (W) einer Eisenbahngleisanlage, das ein Feststellen eines Fehlers der Weiche (W) anhand von während eines Weichenumlaufs gemessenen Messwerten ermöglicht, wobei für eine Mehrzahl an Weichenumläufen jeweils ein Referenzumlaufdatensatz ermittelt wird, der sich jeweils auf zumindest zwei physikalische Messgrößen bezieht, und
das Klassifikationsmodell (KM, KM') auf der Basis dieser Mehrzahl an Referenzumlaufdatensätzen ermittelt wird,
wobei
- für jeden Weichenumlauf der Weiche (W) als Referenzumlaufdatensatz ein zumindest zweidimensionaler, einem vorgegebenen Vektorraum zugeordneter Merkmalsvektor (M) erstellt wird, dessen zumindest zwei Vektorkomponenten sich auf die zumindest zwei während des Weichenumlaufs gemessenen physikalischen Messgrößen beziehen, und
- mit den Merkmalsvektoren (M) ein Raumabschnitt innerhalb des Vektorraumes definiert wird, wobei der Raumabschnitt das Klassifikationsmodell (KM, KM') bildet und zur Bildung des Fehlersignals (SF) eine Prüfung ermöglicht, ob nach Fertigstellung des Klassifikationsmodells (KM, KM') für nachfolgende Weichenumläufe erzeugte Merkmalsvektoren (M) über ein vorgegebenes Maß hinaus außerhalb dieses Raumabschnitts liegen oder nicht,
**dadurch gekennzeichnet, dass** sich die Referenzumlaufdatensatze jeweils auf zumindest zwei während des jeweiligen Weichenumlaufs gemessene physikalische Messgrößen beziehen, wobei
- das Klassifikationsmodell (KM) zunächst auf der Basis von Referenzumlaufdatensätzen ermittelt wird, die sich auf eine vorgegebene Anzahl an Weichenumläufen nach einer Erstinstallation der Weiche (W) oder auf eine vorgegebene Zeitspanne nach der Erstinstallation der Weiche (W) beziehen, und
- nach einer jeden Reparatur oder Wartung ein bestehendes Klassifikationsmodell (KM) unter Bildung eines aktualisierten Klassifikationsmodells (KM') auf der Basis von Referenzumlaufdatensätzen modifiziert wird, die sich auf eine vorgegebene Anzahl an Weichenumläufen nach der jeweiligen Wartung oder Reparatur der Weiche (W) oder auf eine vorgegebene Zeitspanne nach der jeweiligen Wartung oder Reparatur der Weiche (W) beziehen.

2. Verfahren nach Anspruch 1,
**dadurch gekennzeichnet, dass**
das Klassifikationsmodell (KM, KM') unter Heranziehung oder auf der Basis ausschließlich solcher Referenzumlaufdatensätze ermittelt wird, deren zugehörige Weichenumläufe als fehlerfrei angesehen werden.

3. Verfahren nach einem der voranstehenden Ansprüche,
**dadurch gekennzeichnet, dass**
- die Referenzumlaufdatensätze jeweils zumindest auch als eine der gemessenen physikalischen Messgrößen die Umlaufdauer der Weiche (W) angeben.

4. Verfahren nach einem der voranstehenden Ansprüche,
**dadurch gekennzeichnet, dass**
das Klassifikationsmodell (KM, KM') unter Heranziehung oder auf der Basis eines One-Class-Support-Vector-Machine-Verfahrens ermittelt wird.

5. Einrichtung (200, 300, 400, 500) zum Ermitteln eines Klassifikationsmodells (KM, KM') für eine Weiche (W) einer Eisenbahngleisanlage, das ein Feststellen eines Fehlers der Weiche (W) ermöglicht, wobei die Einrichtung (200, 300, 400, 500) dazu ausgebildet ist, das Klassifikationsmodell (KM, KM') auf der Basis einer Mehrzahl an Referenzumlaufdatensätzen zu ermitteln, die sich jeweils auf zumindest zwei physikalische Messgrößen beziehen, wobei die Einrichtung (200, 300, 400, 500) dazu ausgebildet ist,
- für jeden Weichenumlauf der Weiche (W) als Referenzumlaufdatensatz einen zumindest zweidimensionalen, einem vorgegebenen Vektorraum zugeordneten Merkmalsvektor (M) zu erstellen, dessen zumindest zwei Vektorkomponenten sich auf die zumindest zwei während des Weichenumlaufs gemessenen physikalischen Messgrößen beziehen, und
- mit den Merkmalsvektoren (M) einen Raumabschnitt innerhalb des Vektorraumes zu definieren, wobei der Raumabschnitt das Klassifikationsmodell (KM, KM') bildet und zur Bildung des Fehlersignals (SF) eine Prüfung ermöglicht, ob nach Fertigstellung des Klassifikationsmodells (KM, KM') für nachfolgende Weichenumläufe erzeugte Merkmalsvektoren (M) über ein vorgegebenes Maß hinaus außerhalb dieses Raumabschnitts liegen oder nicht,
**dadurch gekennzeichnet, dass** sich die Referenzumlaufdatensatze jeweils auf zumindest zwei während des jeweiligen Weichenumlaufs gemessene physikalische Messgrößen beziehen, wobei die Einrichtung weiter dazu ausgebildet ist,
- das Klassifikationsmodell (KM) zunächst auf der Basis von Referenzumlaufdatensätzen zu ermitteln, die sich auf eine vorgegebene Anzahl an Weichenumläufen nach einer Erstinstallation der Weiche (W) oder auf eine vorgegebene Zeitspanne nach der Erstinstallation der Weiche (W) beziehen, und
- nach einer jeden Reparatur oder Wartung ein bestehendes Klassifikationsmodell (KM) unter Bildung eines aktualisierten Klassifikationsmodells (KM') auf der Basis von Referenzumlaufdatensätzen zu modifizieren, die sich auf eine vorgegebene Anzahl an Weichenumläufen nach der jeweiligen Wartung oder Reparatur der Weiche (W) oder auf eine vorgegebene Zeitspanne nach der jeweiligen Wartung oder Reparatur der Weiche (W) beziehen.

6. Einrichtung (200, 300, 400, 500) nach Anspruch 5,
**dadurch gekennzeichnet, dass**
die Einrichtung (200, 300, 400, 500) eine Recheneinrichtung (210) und einen Speicher (220) aufweist, in dem ein Computerprogrammprodukt (CPP) abgespeichert ist, das bei Ausführung durch die Recheneinrichtung (210) diese veranlasst, ein Verfahren nach einem der Ansprüche 1 bis 10 durchzuführen.

7. Computerprogrammprodukt (CPP),
**dadurch gekennzeichnet, dass**
das Computerprogrammprodukt (CPP) geeignet ist, bei Ausführung durch eine Recheneinrichtung (210) diese zu veranlassen, ein Verfahren nach einem Ansprüche 1 bis 4 durchzuführen.

## Claims

1. Method for determining a classification model (KM, KM') for points (W) of a railway track installation, which makes it possible to establish a fault with the points (W) on the basis of measured values measured during a points switch, wherein a respective reference switch data record is determined for a multiplicity of points switches, which reference switch data record relates in each case to at least two physical measured variables, and
the classification model (KM, KM') is determined on the basis of this multiplicity of reference switch data records, wherein
- for each points switch of the points (W), an at least two-dimensional feature vector (M) associated with a predefined vector space is created as reference switch data record, the at least two vector components of which feature vector relate to the at least two physical measured variables measured during the points switch, and
- the feature vectors (M) define a section of space within the vector space, wherein the section of space forms the classification model (KM, KM') and allows a test, in order to form the fault signal (SF), as to whether or not feature vectors (M) generated following the completion of the classification model (KM, KM') for subsequent points switches lie outside this section of space beyond a predefined extent,
**characterized in that** the reference switch data records each relate to at least two physical measured variables measured during the respective points switch, wherein
- the classification model (KM) is initially determined on the basis of reference switch data records that relate to a predefined number of points switches following initial installation of the points (W) or to a predefined time interval following the initial installation of the points (W), and
- following each repair or maintenance, an existing classification model (KM) is modified by forming an updated classification model (KM') on the basis of reference switch data records relating to a predefined number of points switches following the respective maintenance or repair of the points (W) or to a predefined time interval following the respective maintenance or repair of the points (W).

2. Method according to Claim 1,
**characterized in that** the classification model (KM, KM') is determined using or on the basis solely of reference switch data records whose associated points switches are considered to be fault-free.

3. Method according to either of the preceding claims,
**characterized in that**
- the reference switch data records in each case at least also specify the switching duration of the points (W) as one of the measured physical measured variables.

4. Method according to one of the preceding claims,
**characterized in that**
the classification model (KM, KM') is determined using or on the basis of a one class support vector machine method.

5. Device (200, 300, 400, 500) for determining a classification model (KM, KM') for points (W) of a railway track installation, which makes it possible to establish a fault with the points (W), wherein the device (200, 300, 400, 500) is designed to determine the classification model (KM, KM') on the basis of a multiplicity of reference switch data records that each relate to at least two physical measured variables, wherein the device (200, 300, 400, 500) is designed,
- for each points switch of the points (W), to create an at least two-dimensional feature vector (M) associated with a predefined vector space as reference switch data record, the at least two vector components of which feature vector relate to the at least two physical measured variables measured during the points switch, and
- to use the feature vectors (M) to define a section of space within the vector space, wherein the section of space forms the classification model (KM, KM') and allows a test, in order to form the fault signal (SF), as to whether or not feature vectors (M) generated following the completion of the classification model (KM, KM') for subsequent points switches lie outside this section of space beyond a predefined extent,
**characterized in that** the reference switch data records each relate to at least two physical measured variables measured during the respective points switch, wherein the device is furthermore designed
- to initially determine the classification model (KM) on the basis of reference switch data records that relate to a predefined number of points switches following initial installation of the points (W) or to a predefined time interval following the initial installation of the points (W), and
- following each repair or maintenance, to modify an existing classification model (KM) by forming an updated classification model (KM') on the basis of reference switch data records relating to a predefined number of points switches following the respective maintenance or repair of the points (W) or to a predefined time interval following the respective maintenance or repair of the points (W).

6. Device (200, 300, 400, 500) according to Claim 5,
**characterized in that**
the device (200, 300, 400, 500) has a computing device (210) and a memory (220) storing a computer program product (CPP) that, when executed by the computing device (210), prompts same to perform a method according to one of Claims 1 to 10.

7. Computer program product (CPP),
**characterized in that**
the computer program product (CPP) is suitable, when executed by a computing device (210), for prompting same to perform a method according to one of Claims 1 to 4.

## Revendications

1. Procédé d'établissement d'un modèle (KM, KM*'*) de classification d'un aiguillage (W) d'une installation ferroviaire, qui permet de constater une erreur de l'aiguillage (W), à l'aide de valeurs de mesure mesurées pendant un cycle de l'aiguillage, dans lequel pour une pluralité de cycles de l'aiguillage, on établit respectivement un ensemble de données de cycle de référence, qui se rapporte respectivement à au moins deux grandeurs physiques de mesure, et
on établit le modèle (KM, KM*'*) de classification sur la base de cette pluralité d'ensembles de données de cycle de référence,
dans lequel
- pour chaque cycle de l'aiguillage (W), on crée, comme ensemble de données de cycle de référence, un vecteur (M) de caractéristique au moins bidirectionnel associé à un espace vectoriel donné à l'avance, dont au moins deux composantes vectorielles se rapportent à les au moins deux grandeurs physiques de mesure mesurées pendant le cycle de l'aiguillage, et
- par les vecteurs (M) de caractéristique, on définit un segment spatial dans l'espace vectoriel, dans lequel le segment spatial forme le modèle (KM, KM*'*) de classification et permet, pour la formation du signal (SF) de défaut, une vérification du point de savoir si, après l'achèvement du modèle (KM, KM*'*) de classification, il y a ou il n'y a pas, pour des vecteurs (M) de caractéristique produits pour des cycles suivants de l'aiguillage, une mesure donnée à l'avance au-delà de ce segment spatial,
**caractérisé en ce que** l'ensemble de données de cycle de référence se rapporte respectivement à au moins deux grandeurs physiques de mesure mesurées pendant le cycle respectif de l'aiguillage, dans lequel
- on établit le modèle (KM) de classification, d'abord sur la base d'ensembles de données de cycle de référence, qui se rapportent à un nombre donné à l'avance de cycles de l'aiguillage après une première installation de l'aiguillage (W) ou sur un laps de temps donné à l'avance après la première installation de l'aiguillage (W), et
- après chaque réparation ou entretien, on modifie un modèle (KM) existant de classification en formant un modèle (KM*'*) mis à jour de classification sur la base des ensembles de données de cycle de référence, qui se rapportent à un nombre donné à l'avance de cycles de l'aiguillage après l'entretien ou la réparation respective de l'aiguillage (W) ou sur un laps de temps, donné à l'avance après l'entretien ou la réparation, respectif de l'aiguillage (W).

2. Procédé suivant la revendication 1,
**caractérisé en ce que** l'
on établit le modèle (KM, KM*'*) de classification en tirant parti exclusivement des ensembles de données de cycle de référence, dont les cycles de l'aiguillage, qui lui appartiennent, sont considérés comme sans défaut.

3. Procédé suivant l'une des revendications précédentes,
**caractérisé en ce que**
- les ensembles de données de cycle de référence indiquent également aussi, comme l'une des grandeurs physiques de mesure mesurées, la durée du cycle de l'aiguillage (W).

4. Procédé suivant l'une des revendications précédentes, **caractérisé en ce que** l'
on établit le modèle (KM, KM*'*) de classification en tirant parti ou sur la base d'un procédé one-class-support-vector-machine.

5. Dispositif (200, 300, 400, 500) d'établissement d'un modèle (KM, KM*'*) de classification pour un aiguillage (W) d'une installation ferroviaire, qui permet de constater un défaut de l'aiguillage (W), dans lequel le dispositif (200, 300, 400, 500) est constitué pour établir le modèle (KM, KM*'*) de classification sur la base d'une pluralité d'ensembles de données de cycle de référence, qui se rapportent respectivement à au moins deux grandeurs physiques de mesure, dans lequel le dispositif (200, 300, 400, 500) est constitué,
- pour chaque cycle de l'aiguillage (W), on crée comme ensemble de données de cycle de référence, un vecteur (M) de caractéristique au moins bidirectionnel associé à un espace vectoriel donné à l'avance, dont au moins deux composantes vectorielles se rapportent au au moins deux grandeurs physiques de mesure mesurées pendant le cycle de l'aiguillage, et
- par les vecteurs (M) de caractéristique, on définit un segment spatial dans l'espace vectoriel, dans lequel le segment spatial forme le modèle (KM, KM*'*) de classification et permet, pour la formation du signal (SF) de défaut, une vérification sur le point de savoir, si après l'achèvement du modèle (KM, KM*'*) de classification, il y a ou il n'y a pas, pour des vecteurs (M) de caractéristique produits pour des cycles suivants de l'aiguillage, une mesure donnée à l'avance au-delà de ce segment spatial,
**caractérisé en ce que** l'ensemble de données de cycle de référence se rapporte respectivement à au moins deux grandeurs physiques de mesure mesurées pendant le cycle respectif de l'aiguillage, dans lequel le dispositif est constitué, en outre, pour
- établir le modèle (KM) de classification, d'abord sur la base d'ensembles de données de cycle de référence, qui se rapportent à un nombre donné à l'avance de cycles de l'aiguillage après une première installation de l'aiguillage (W) ou sur un laps de temps donné à l'avance après la première installation de l'aiguillage (W), et
- après chaque réparation ou entretien, on modifie un modèle (KM) existant de classification en formant un modèle (KM*'*) mis à jour de classification sur la base des ensembles de données de cycle de référence, qui se rapportent à un nombre donné à l'avance de cycles de l'aiguillage après l'entretien ou la réparation respective de l'aiguillage (W) ou sur un laps de temps, donné à l'avance après l'entretien ou la réparation, respectif de l'aiguillage (W).

6. Dispositif (200, 300, 400, 500) suivant la revendication 5,
**caractérisé en ce que**
le dispositif (200, 300, 400, 500) comporte un dispositif (210) informatique, et une mémoire (220), dans laquelle est mis en mémoire un produit (CPP) de programme d'ordinateur, qui, lors de l'exécution par le dispositif (210) informatique, fait qu'un procédé suivant l'une des revendications 1 à 10 est exécuté.

7. Produit (CPP) de programme d'ordinateur,
**caractérisé en ce que**
le produit (CPP) de programme d'ordinateur est propre à faire en sorte, lors de l'exécution par un dispositif (210) informatique, que celui-ci exécute un procédé suivant l'une des revendications 1 à 4.
